# EUROPEAN PATENT APPLICATION

(11) **EP 1 186 685 A2**
(43) Date of publication of application: **13.03.2002**
(21) Application number: 01119360.4
(22) Date of filing: 10.08.2001
(51) Int. Cl.: C23C 16/32, H01L 21/314, H01L 21/768

(54) **Method for forming silicon carbide films**

(30) Priority: 08.09.2000 US 657392
(71) Applicant: Applied Materials, Inc., Santa Clara, California 95054 (US)
(72) Inventor: Xu, Zhi, Albany, CA 94706 (US); XU, Ping, Fremont, CA 94539 (US); Xia, Lin-Qun, Santa Clara, CA 95054 (US); Venkataraman, Chankar, Santa Clara, CA 95051 (US); Yieh, Ellie, San Jose, CA 95138 (US)
(74) Representative: Kirschner, Klaus Dieter, Dipl.-Phys.

(57) **Abstract**

A method of forming a multilayer silicon carbide stack is described. The multilayer silicon carbide stack comprises a thin silicon carbide seed layer (e. g., silicon carbide seed layer less than about 100 Å thick) having a thicker silicon carbide layer (e. g., silicon carbide layer at least 300 Å thick) formed thereon. The multilayer silicon carbide stack is formed by depositing the thin silicon carbide seed layer on a substrate. After the silicon carbide seed layer is deposited on the substrate it is treated with a helium containing plasma. Thereafter, the thicker silicon carbide layer is deposited on the plasma treated silicon carbide seed layer. The multilayer silicon carbide stack is compatible with integrated circuit fabrication processes. In one integrated circuit fabrication process, the multilayer silicon carbide stack is used as a barrier layer. In another integrated circuit fabrication process, the multilayer silicon carbide stack is used as a hardmask for fabricating an interconnect structure.

## Description

The invention relates to low dielectric constant (k) materials and, more particularly, to low dielectric constant (k) silicon carbide films, as well as the deposition thereof.

Integrated circuits have evolved into complex devices that can include millions of components (e. g., transistors, capacitors and resistors) on a single chip. The evolution of chip designs continually requires faster circuitry and greater circuit densities. The demands for greater circuit densities necessitate a reduction in the dimensions of the integrated circuit components.

As the dimensions of the integrated circuit components are reduced (e. g., sub-micron dimensions), the materials used to fabricate such components contribute to the electrical performance of such components. For example, low resistivity metal interconnects (e. g., aluminum and copper) provide conductive paths between the components on integrated circuits. Typically, the metal interconnects are electrically isolated from each other by an insulating material. When the distance between adjacent metal interconnects and/or the thickness of the insulating material has sub-micron dimensions, capacitive coupling potentially occurs between such interconnects. Capacitive coupling between adjacent metal interconnects may cause cross talk and/or resistance-capacitance (RC) delay, which degrades the overall performance of the integrated circuit. In order to minimize capacitive coupling between adjacent metal interconnects, low dielectric constant (low k) insulating materials (e. g., dielectric constants less than about 4.5) are needed.

In addition, a barrier layer often separates the metal interconnects from the low dielectric constant (low k) insulating materials. The barrier layer minimizes the diffusion of interconnect metal into the insulating material. Diffusion of the interconnect metal into the insulating material is undesirable because such diffusion can affect the electrical performance of the integrated circuit, or render it inoperative.

Silicon carbides have been suggested for use as barrier layers on integrated circuits, since silicon carbides can have low dielectric constants (dielectric constants less than about 4.5) and are good diffusion barriers.

However, silicon carbide barrier layers are typically formed using chemical vapor deposition (CVD) techniques. Silicon carbide layers formed using CVD techniques tend to have a high oxygen content (e. g., oxygen content greater than about 4 %). A high oxygen content is undesirable because it may enhance the diffusion of metals such as, for example, copper, from the metal interconnects through the silicon carbide barrier layer into the insulating material.

Therefore, a need exists in the art for a method of forming a reliable silicon carbide diffusion barrier for integrated circuit fabrication.

A method of forming a multilayer silicon carbide stack for use in integrated circuit fabrication processes is provided. The multilayer silicon carbide stack comprises a thin silicon carbide seed layer (e. g., silicon carbide seed layer less than about 100 Å thick) having a thicker silicon carbide layer (e. g., silicon carbide layer at least 300 Å thick) formed thereon.

The multilayer silicon carbide stack is formed by depositing the thin silicon carbide seed layer on a substrate. After the silicon carbide seed layer is deposited on the substrate it is treated with a helium containing plasma. Thereafter, the thicker silicon carbide layer is deposited on the plasma treated silicon carbide seed layer.

The multilayer silicon carbide stack is compatible with integrated circuit fabrication processes. In one integrated circuit fabrication process, the multilayer silicon carbide stack is used as a barrier layer. For such an integrated circuit fabrication process, a preferred process sequence includes depositing the multilayer silicon carbide stack on a metal layer formed on a substrate. Thereafter, one or more metal and/or low dielectric constant (k) layers are form on the multilayer silicon carbide stack.

In another integrated circuit fabrication process, the multilayer silicon carbide stack is used as a hardmask for fabricating integrated circuit structures such as, for example, an interconnect structure. For such an integrated circuit fabrication process, a preferred process sequence includes forming a multilayer silicon carbide stack on a substrate having a first dielectric material thereon. The multilayer silicon carbide stack is then patterned to define vias. After the multilayer silicon carbide stack is patterned, a second dielectric layer is formed thereon and patterned to form interconnects. The interconnects formed in the second dielectric layer are positioned over the vias defined in the multilayer silicon carbide stack. After the second dielectric layer is patterned, the vias defined in the silicon carbide stack are transferred through the first dielectric layer using the multilayer silicon carbide stack as a hardmask. Thereafter, the interconnect structure is completed by filling the interconnects and vias with a conducting material.

According to further aspects an preferred embodiments of the invention, there is provided:
1. A method of forming a multilayer silicon carbide stack on a substrate, comprising (a) forming a silicon carbide seed layer on a substrate; (b) treating the silicon carbide seed layer with a helium containing plasma; and (c) forming a silicon carbide layer on the plasma treated silicon carbide seed layer.
2. A method of forming a device, comprising (a) providing a substrate; (b) forming a multilayer silicon carbide stack on the substrate; and (c) depositing a conductive material on the multilayer silicon carbide stack, wherein the multilayer silicon carbide stack blocks the diffusion of conductive material into the substrate.
3. A method of forming a device, comprising (a) providing a substrate having a first dielectric layer thereon; (b) forming a multilayer silicon carbide stack on the first dielectric layer; (c) patterning the multilayer silicon carbide stack to define vias therein; (d) forming a second dielectric layer on the patterned multilayer silicon carbide stack; (e) patterning the second dielectric layer to define interconnects therein, wherein the interconnects are positioned over the vias defined in the multilayer silicon carbide stack; (f) transferring the via pattern through the first dielectric layer using the multilayer silicon carbide stack as a hardmask; and (g) filling the vias and interconnects with a conductive material.
4. The method above wherein the first dielectric layer and the second dielectric layer each have a dielectric constant less than about 3.0.
5. The method above wherein either of the first dielectric layer and the second dielectric layer are selected from the group of silicon dioxide, fluorosilicate glass (FSG), undoped silicate glass (USG), organosilicates, and combinations thereof.
6. The method above wherein the conductive material filling the vias and the interconnects has a resistivity less than about 10 µΩ-cm (microohms-centimeter).
7. The method above wherein the conductive material filling the vias and the interconnects is selected from the group of copper (Cu), aluminum (Al), tungsten (W), and combinations thereof.
8. The method above wherein the multilayer silicon carbide stack is formed on the first dielectric layer by (a) forming a silicon carbide seed layer on the substrate; (b) treating the silicon carbide seed layer with a helium containing plasma; and (c) forming a silicon carbide layer on the plasma treated silicon carbide layer.
9. The method above wherein the silicon carbide seed layer is treated with the helium containing plasma for less than about 60 seconds.
10. The method above wherein steps (a) or (c), comprise positioning the substrate in a deposition chamber; providing a gas mixture to the deposition chamber wherein the gas mixture comprises a silicon source, a carbon source, and an inert gas; and reacting the gas mixture in the presence of an electric field to form a silicon carbide layer on the substrate.
11. The method above wherein the silicon source and the carbon source comprise an organosilane compound having the general formula SiₓC_{y}H_{z}, wherein x has a range of 1 to 2, y has a range of 1 to 6, and z has a range of 4 to 20.
12. The method above wherein the organosilane compound is selected from the group of methylsilane (SiCH₆), dimethylsilane (SiC₂H₈), trimethylsilane (SiC₃H₁₀), tetramethylsilane (SiC₄H₁₂), diethylsilane (SiC₄H₁₂), and combinations thereof.
13. The method above wherein the silicon source and the carbon source are selected from the group of silane (SiH₄), methane (CH₄), disilane (Si₂H₆), and combinations thereof.
14. The method above wherein the inert gas is selected from the group of argon (Ar), helium (He), neon (Ne), xenon (Xe), and combinations thereof.
15. The method above wherein the substrate is heated to a temperature between about 200 °C to about 400 °C.
16. The method above wherein the deposition chamber is maintained at a pressure between about 3 torr to about 15 torr.
17. The method above wherein the gas mixture is provided to the deposition chamber at a flow rate in a range of about 50 sccm to about 3000 sccm.
18. The method above wherein the inert gas is provided to the deposition chamber at a flow rate in a range of about 100 sccm to about 4000 sccm.
19. The method above wherein the electric field is generated from a radio frequency (RF) power.
20. The method above wherein the RF power is in a range of about 3.18 x 10⁻⁵ watts/cm² to about2.54 x 10⁻⁴ watts/cm².
21. The method above wherein the silicon carbide seed layer deposited in step (a) has a thickness in a range of about 50 Å to about 100 Å.
22. The method above wherein the silicon carbide layer deposited in step (c) has a thickness in a range of about 400 Å to about 1000 Å.
23. The method above wherein the helium containing plasma of step (b) is generated by providing a helium containing gas to a process chamber; and applying an electric field to the helium containing gas in the process chamber to generate the helium containing plasma.
24. The method above wherein the process chamber is maintained at a pressure in a range of about 5 torr to about 10 torr.
25. The method above wherein the helium containing gas is provided to the deposition chamber at a flow rate in a range of about 1000 sccm to about 3000 sccm.
26. The method above wherein the electric field is generated from a radio frequency (RF) power.
27. The method above wherein the RF power is in a range of about 6.37 x 10⁻⁵ watts/cm² to about 2.54 x 10⁻⁴ watts/cm².
28. The method above wherein the helium containing plasma of step (b) is generated in the process chamber used for the silicon carbide layer deposition.
29. The method above wherein the helium containing plasma of step (b) is generated in a process chamber different from that used for the silicon carbide layer deposition.
30. A computer storage medium containing a software routine that, when executed, causes a general purpose computer to control a deposition chamber using a any of the layer deposition methods above.
31. A multilayer silicon carbide stack, comprising a plasma treated silicon carbide seed layer formed on a substrate; and a silicon carbide layer formed on the plasma treated silicon carbide seed layer.
32. The multilayer silicon carbide stack above formed according to any of the above methods.

The teachings of the present invention can be readily understood by considering the following detailed description in conjunction with the accompanying drawings, in which:
- FIG. 1: depicts a schematic illustration of an apparatus that can be used for the practice of embodiments described herein;
- FIG. 2: depicts a schematic illustration of an alternate apparatus including a remote plasma source that can be used for the practice of embodiments described herein;
- FIGs. 3a-3d: depict schematic cross-sectional views of a substrate structure at different stages of integrated circuit fabrication incorporating a multilayer silicon carbide stack as a barrier layer; and
- FIGs. 4a-4h: depict schematic cross-sectional views of an interconnect structure at different stages of integrated circuit fabrication incorporating a multilayer silicon carbide stack as a hardmask.

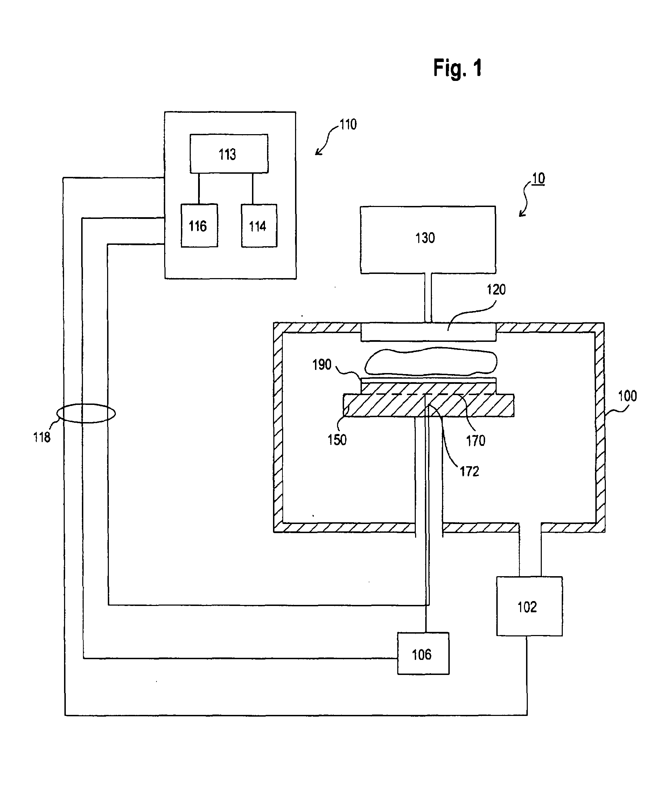

FIG. 1 is a schematic representation of a wafer processing system 10 that can be used to perform multilayer silicon carbide stack formation in accordance with embodiments described herein. System 10 typically comprises a process chamber 100, a gas panel 130, a control unit 110, along with other hardware components such as power supplies 106 and vacuum pumps 102. Examples of wafer processing system 10 include plasma enhanced chemical vapor deposition (PECVD) chambers such as DxZ™ chambers and PRODUCER™ chambers, commercially available from Applied Materials, Inc., located in Santa Clara, California. The salient features of this system 10 are briefly described below.

The process chamber 100 generally houses a support pedestal 150, which is used to support a substrate such as a semiconductor wafer 190. This pedestal 150 can typically be moved in a vertical direction inside the chamber 100 using a displacement mechanism (not shown).

Depending on the specific process, the wafer 190 can be heated to some desired temperature prior to the silicon carbide layer structure deposition. For example, the wafer support pedestal 150 is heated by an embedded heater element 170. The pedestal 150 may be resistively heated by applying an electric current from an AC power supply 106 to the heater element 170. The wafer 190 is, in turn, heated by the pedestal 150.

A temperature sensor 172, such as a thermocouple, is also embedded in the wafer support pedestal 150 to monitor the temperature of the pedestal 150 in a conventional manner. The measured temperature is used in a feedback loop to control the power supplied to the heater element 170, such that the wafer temperature can be maintained or controlled at a desired temperature which is suitable for the particular process application. The pedestal is optionally heated using radiant heat (not shown).

A vacuum pump 102, is used to evacuate the process chamber 100 and to maintain the proper gas flows and pressure inside the chamber 100. A showerhead 120, through which process gases are introduced into the chamber 100, is located above the wafer support pedestal 150. The showerhead 120 is coupled to a gas panel 130, which controls and supplies various gases used in different steps of the process sequence.

The showerhead 120 and wafer support pedestal 150 also form a pair of spaced apart electrodes. When an electric field is generated between these electrodes, the process gases introduced into the chamber 100 are ignited into a plasma. Typically, the electric field is generated by connecting the wafer support pedestal 150 to a source of RF power (not shown) through a matching network (not shown). Alternatively, the RF power source and matching network may be coupled to the showerhead 120, or coupled to both the showerhead 120 and the wafer support pedestal 150.

Plasma enhanced chemical vapor deposition (PECVD) techniques promote excitation and/or disassociation of the reactant gases by the application of the electric field to the reaction zone near the substrate surface, creating a plasma of reactive species. The reactivity of the species in the plasma reduces the energy required for a chemical reaction to take place, in effect lowering the required temperature for such PECVD processes.

Proper control and regulation of the gas flows through the gas panel 130 is performed by mass flow controllers (not shown) and the controller unit 110. The showerhead 120 allows process gases from the gas panel 130 to be uniformly introduced and distributed in the process chamber 100.

Illustratively, the control unit 110 comprises a central processing unit (CPU) 113, support circuitry 114, and memories containing associated control software 116. The control unit 110 is responsible for automated control of the numerous steps required for wafer processing-such as wafer transport, gas flow control, mixed RF power control, temperature control, chamber evacuation, and other steps. Bi-directional communications between the control unit 110 and the various components of the wafer processing system 10 are handled through numerous signal cables collectively referred to as signal buses 118, some of which are illustrated in FIG. 1.

The central processing unit (CPU) 113 may be one of any form of general purpose computer processor that can be used in an industrial setting for controlling process chambers as well as sub-processors. The computer may use any suitable memory, such as random access memory, read only memory, floppy disk drive, hard drive, or any other form of digital storage, local or remote. Various support circuits may be coupled to the CPU for supporting the processor in a conventional manner. Process sequence routines as required may be stored in the memory or executed by a second CPU that is remotely located.

The process sequence routines are executed after the substrate 190 is positioned on the wafer support pedestal 150. The process sequence routines, when executed, transform the general purpose computer into a specific process computer that controls the chamber operation so that the deposition process is performed. Alternatively, the chamber operation may be controlled using remotely located hardware, as an application specific integrated circuit or other type of hardware implementation, or a combination of software and hardware.

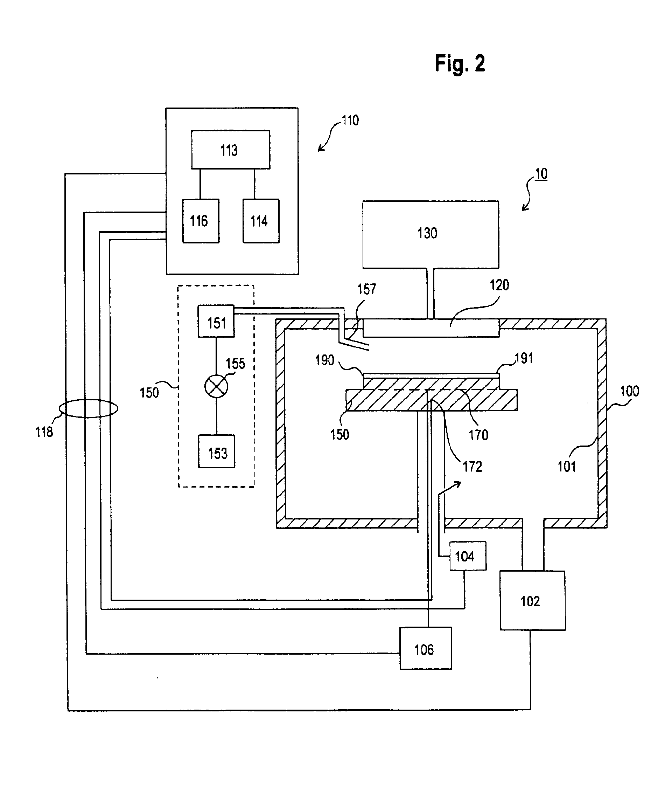

Optionally, a remote plasma source 150 may be coupled to wafer processing system 10, as shown in FIG. 2 to provide a remotely generated plasma to the process chamber 100. The remote plasma source 150 includes a gas supply 153, a gas flow controller 155, a plasma chamber 151, and a chamber inlet 157. The gas flow controller 155 controls the flow of process gas from the gas supply 153 to the plasma chamber 151.

A remote plasma may be generated by applying an electric field to the process gas in the plasma chamber 151, creating a plasma of reactive species. Typically, the electric field is generated in the plasma chamber 151 using a RF power source (not shown). The reactive species generated in the remote plasma source 150 are introduced into the process chamber 100 through inlet 157.

### Multilayer Silicon Carbide Stack Formation

In one embodiment, the multilayer silicon carbide stack is formed by first depositing a thin silicon carbide seed layer on a substrate. The silicon carbide seed layer is formed by reacting a gas mixture comprising a silicon source, a carbon source, and an inert gas.

The silicon source and the carbon source may be an organosilane compound having the general formula SiₓC_{y}H_{z}, where x has a range from 1 to 2, y has a range from 1 to 6, and z has a range from 6 to 20. For example, methylsilane (SiCH₆), dimethylsilane (SiC₂H₈), trimethylsilane (SiC₃H₁₀), and tetramethylsilane (SiC₄H₁₂), among others may be used as the organosilane compound. Alternatively, silane (SiH₄), disilane (Si₂H₆), methane (CH₄), and combinations thereof may be used as the silicon source and the carbon source. Helium (He), argon (Ar), neon (Ne), and xenon (Xe), as well as combinations thereof, among others, may be used for the inert gas.

In general, the following deposition process parameters can be used to form the silicon carbide seed layer in a deposition chamber similar to that shown in FIG. 1. The process parameters range from a wafer temperature of about 200 °C to about 400 °C, a chamber pressure of about 3 torr to about 15 torr, a gas mixture flow rate of about 50 sccm to about 3000 sccm, an inert gas flow rate of about 100 sccm to about 4000 sccm, a plate spacing of about 300 mils to about 600 mils, and a radio frequency (RF) power of about 3.18 x 10⁻⁵ watts/cm² to about 2.54 x 10⁻⁴ watts/cm². The above process parameters provide a deposition rate for the silicon carbide seed layer in a range of about 500 Å/sec to about 2000 Å/sec when implemented on a 200 mm (millimeter) substrate in a deposition chamber available from Applied Materials, Inc., located in Santa Clara, California. Typically, the silicon carbide seed layer is deposited to a thickness of about 50 Å to about 100 Å.

Other deposition chambers are within the scope of the invention, and the parameters listed above may vary according to the particular deposition chamber used to form the silicon carbide seed layer. For example, other deposition chambers may have a larger (e. g., configured to accommodate 300 mm substrates) or smaller volume, requiring gas flow rates that are larger or smaller than those recited for deposition chambers available from Applied Materials, Inc.

After the silicon carbide seed layer is formed, it is treated with a helium containing plasma. In general, the following process parameters can be used to plasma treat the silicon carbide seed layer in a process chamber similar to that shown in FIG. 1 or FIG. 2. The process parameters range from a wafer temperature of about 200 °C to about 400 °C, a chamber pressure of about 5 torr to about 10 torr, a helium containing gas flow rate of about 1000 sccm to about 3000 sccm, and a radio frequency (RF) power of about 6.37 x 10⁻⁵ watts/cm² to about 2.54 x 10⁻⁴ watts/cm². The silicon carbide seed layer is plasma treated for less than about 60 seconds.

Thereafter, the thicker silicon carbide layer is deposited on the plasma treated silicon carbide seed layer. The thicker silicon carbide layer is formed on the silicon carbide seed layer according to the process parameters described above with reference to the silicon carbide seed layer. Typically, the thicker silicon carbide layer is deposited to a thickness of about 400 Å to about 1000 Å.

After the thicker silicon carbide layer is formed on the silicon carbide seed layer, it is optionally treated with a helium containing plasma. Such silicon carbide layer may be treated with the helium containing plasma according to the process conditions described above.

The treatment of the silicon carbide seed layer with the helium containing plasma reduces the oxygen content of such layer. It is believed that reducing the oxygen content minimizes metal diffusion and improves the barrier layer properties of the multilayer silicon carbide stack. For example, a dual plasma treated multilayer silicon carbide stack has a leakage current of less than about 1 x 10⁻¹¹ A/cm² at 1 MV/cm², which is suitable for minimizing cross-talk between integrated circuit interconnect structures.

The treatment of the silicon carbide seed layer with the helium containing plasma also reduces the hydrogen content of such layer. It is believed that reducing the hydrogen content of the multilayer stack increases the etch selectivity between the silicon carbide layers and other dielectric materials such as, for example, organosilicates.

In addition, the helium plasma treatment improves the adhesion of the multilayer silicon carbide stack to both overlying material layers and underlying material layers. For example, the tensile stress of plasma treated silicon carbide layers tends to be lower than that of untreated layers, minimizing peeling and/or cracking of treated layers so as to improve their adhesion to other layers.

### Integrated Circuit Fabrication Process

### A. Integrated Circuit Structure Incorporating a Multilayer Silicon Carbide Stack as a Barrier Layer

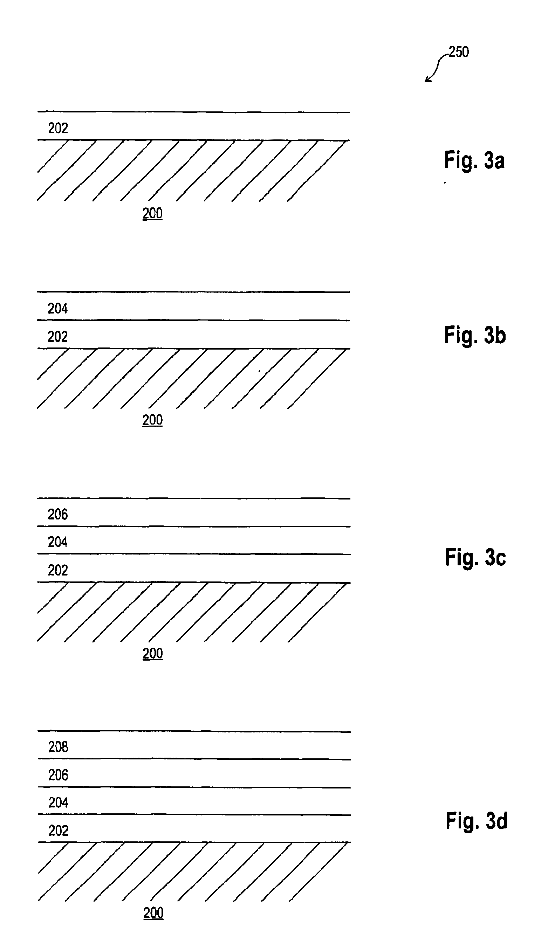

FIGS. 3a-3d illustrate schematic cross-sectional views of a substrate 200 at different stages of an integrated circuit fabrication sequence incorporating a multilayer silicon carbide stack as a barrier layer. In general, the substrate 200 refers to any workpiece on which processing is performed, and a substrate structure 250 is used to generally denote the substrate together with other material layers formed on the substrate 200. Depending on the specific stage of processing, the substrate 200 may correspond to a silicon wafer, or other material layer that has been formed on the silicon wafer. FIG. 3a, for example, illustrates a cross-sectional view of a substrate structure 250, having a first material layer 202 that has been conventionally formed thereon. The first material layer 202 may be an oxide (e. g., silicon dioxide) or a metal (e. g., copper (Cu)). In general, the substrate 200 may include a layer of silicon, silicides, metals, or other materials. FIG. 3a illustrates one embodiment in which the substrate 200 is silicon having a copper layer formed thereon.

FIG. 3b depicts a silicon carbide seed layer 204 formed on the substrate structure 250 of FIG. 3a. The silicon carbide seed layer 204 is formed on the substrate structure 250 according to the process parameters described above. The thickness of the silicon carbide seed layer 204 is variable depending on the specific stage of processing. Typically, the silicon carbide seed layer is deposited to a thickness of about 50 Å to about 100 Å.

After the silicon carbide seed layer 204 is formed on the substrate structure 250, it is treated with a helium containing plasma. The silicon carbide seed layer 204 is treated with the helium containing plasma according to the process conditions described above.

Referring to FIG. 3c, a thicker silicon carbide layer 206 is formed on the plasma treated silicon carbide seed layer 204. The silicon carbide layer 206 is formed on the silicon carbide seed layer 204 according to the process parameters described above. The thickness of the silicon carbide layer 206 is variable depending on the specific stage of processing. Typically, the silicon carbide layer is deposited to a thickness of about 400 Å to about 1000 Å.

After the thicker silicon carbide layer 206 is formed on the silicon carbide seed layer 204, it is optionally treated with a helium containing plasma. The silicon carbide layer 206 may be treated with the helium containing plasma according to the process conditions described above.

Referring to FIG. 3d, after the silicon carbide layer 206 is formed on the silicon carbide seed layer 204 and optionally plasma treated, the integrated circuit structure is completed by forming a second material layer 208 thereon. The second material layer 208 may be an oxide (e. g. silicon dioxide, fluorosilicate glass (FSG), undoped silicate glass (USG), organosilicate, silicon carbide) or metal (e. g., copper, tungsten, aluminum). The second material layer may be formed using chemical vapor deposition (CVD), physical vapor deposition (PVD), electroplating, or combinations thereof.

### B. Interconnect Structure Incorporating a Multilayer

### Silicon Carbide Stack as a Hardmask

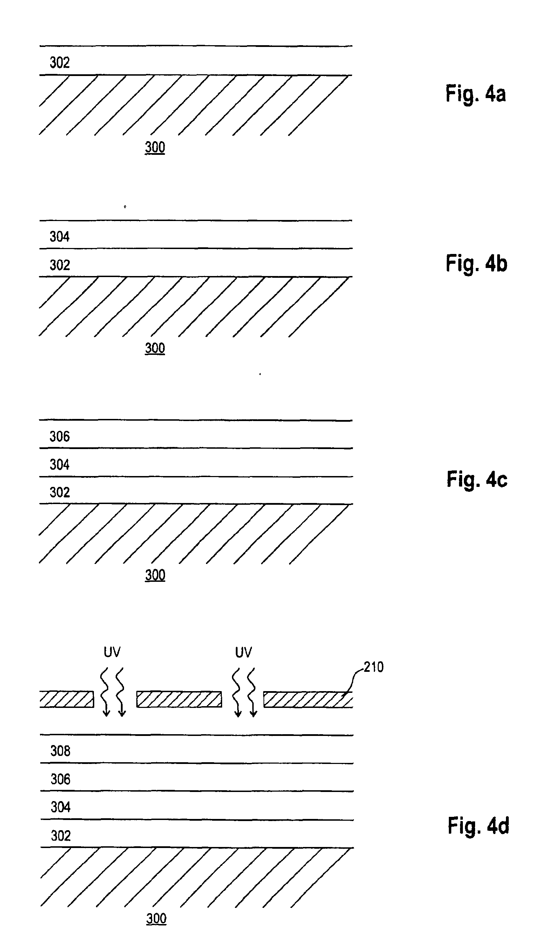

FIGS. 4a-4h illustrate schematic cross-sectional views of a substrate 300 at different stages of an interconnect structure fabrication sequence incorporating a multilayer silicon carbide stack as a hardmask. Depending on the specific stage of processing, substrate 300 may correspond to a silicon wafer, or other material layer that has been formed on the substrate 300. FIG. 4a, for example, illustrates a cross-sectional view of a substrate 300 having a first dielectric layer 302 formed thereon. The first dielectric layer 302 may be an oxide (e. g., silicon dioxide, fluorosilicate glass (FSG), undoped silicate glass (USG), organosilicate). In general, the substrate may include a layer of silicon, silicides, metals, or other material layers.

FIG. 4a illustrates one embodiment in which the substrate 300 is silicon and the first dielectric layer 302 formed thereon, is a fluorosilicate glass (FSG) layer. The first dielectric layer 302 has a thickness of about 5,000 Å to about 10,000 Å, depending on the size of the structure to be fabricated.

Referring to FIG. 4b, a silicon carbide seed layer 304 is formed on the first dielectric layer 302. The silicon carbide seed layer is formed according to the process parameters described above. The thickness of the silicon carbide seed layer 304 is variable depending on the specific stage of processing. Typically, the silicon carbide seed layer 304 has a thickness of about 50 Å to about 100 Å.

After the silicon carbide seed layer 304 is formed on the first dielectric layer, it is treated with a helium containing plasma. The silicon carbide seed layer 304 is treated with the helium containing plasma according to the process conditions described above.

Referring to FIG. 4c, a silicon carbide layer 306 is formed on the plasma treated silicon carbide seed layer 304. The silicon carbide layer 306 is formed on the silicon carbide seed layer 304 according to the process parameters described above with reference to FIG. 3c. The thickness of the silicon carbide layer 306 is variable depending on the specific stage of processing. Typically, the silicon carbide layer 306 is deposited to a thickness of about 400 Å to about 1000 Å.

After the silicon carbide layer 306 is formed on the silicon carbide seed layer 304, it is optionally treated with a helium containing plasma. The silicon carbide layer 306 may be treated with the helium containing plasma according to the process conditions described above.

After the silicon carbide layer 306 is plasma treated, the multilayer silicon carbide stack 304, 306 is patterned to define vias therein. Referring to FIG. 4d, a layer of energy sensitive resist material 308 is formed on the multilayer silicon carbide stack 304, 306.

The layer of energy sensitive resist material 308 may be spin coated on the substrate to a thickness within a range of about 4,000 Å to about 10,000 Å. Most energy sensitive resist materials are sensitive to ultraviolet (UV) radiation having a wavelength less than about 450 nm (nanometers). Deep ultraviolet radiation (DUV) resist materials are sensitive to UV radiation having wavelengths less than about 245 nm.

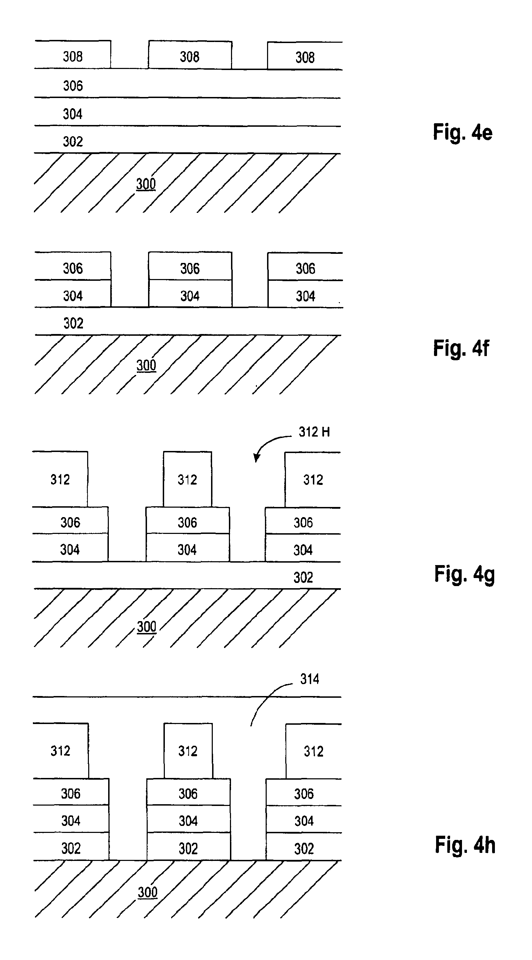

An image of a pattern is introduced into the layer of energy sensitive resist material 308 by exposing such energy sensitive resist material 308 to UV radiation via mask 310. The image of the pattern introduced in the layer of energy sensitive resist material 308 is developed in an appropriate developer to define the pattern therethrough, as depicted in FIG. 4e. Thereafter, referring to FIG. 4f, the pattern defined in the energy sensitive resist material 308 is transferred through the multilayer silicon carbide stack 304, 306. The pattern is transferred through the multilayer silicon carbide stack 304, 306 using the energy sensitive resist material 308 as a mask. The pattern is transferred through the multilayer silicon carbide stack 304, 306 using an appropriate chemical etchant. For example, fluorocarbon compounds such as trifluoromethane (CF₃H) may be used to chemically etch the multilayer silicon carbide stack 304, 306.

After the multilayer silicon carbide stack is patterned, a second dielectric layer 312 is formed thereon and patterned to define interconnects 312H, as depicted in FIG. 4g. The second dielectric layer 312 may be an oxide (e. g. silicon dioxide, fluorosilicate glass (FSG), undoped silicate glass (USG), organosilicate). The second dielectric layer 308 has a thickness of about 5,000 Å to about 10,000 Å.

The second dielectric layer 312 is patterned using the conventional lithography processes described above. The interconnects 312H formed in the second dielectric layer 312 are positioned over the via openings in the multilayer silicon carbide stack 304, 306. Thereafter, the vias are etched through the first dielectric layer 302 using the multilayer silicon carbide stack as a hardmask. The first dielectric layer 302 is etched using reactive ion etching or other anisotropic etching techniques.

Referring to FIG. 4h, the interconnects and vias are filled with a conductive material 314 such as aluminum (Al), copper (Cu), tungsten (W), and combinations thereof, among others. The conductive material 314 is deposited using chemical vapor deposition (CVD), physical vapor deposition (PVD), electroplating, or combinations thereof.

## Claims

1. A method of forming a multilayer silicon carbide stack on a substrate, comprising:
(a) forming a silicon carbide seed layer on a substrate;
(b) treating the silicon carbide seed layer with a helium containing plasma; and
(c) forming a silicon carbide layer on the plasma treated silicon carbide seed layer.

2. A method of forming a device, comprising:
(a) providing a substrate;
(b) forming a multilayer silicon carbide stack on the substrate; and
(c) depositing a conductive material on the multilayer silicon carbide stack, wherein the multilayer silicon carbide stack blocks the diffusion of conductive material into the substrate.

3. A method of forming a device, comprising:
(a) providing a substrate having a first dielectric layer thereon;
(b) forming a multilayer silicon carbide stack on the first dielectric layer;
(c) patterning the multilayer silicon carbide stack to define vias therein;
(d) forming a second dielectric layer on the patterned multilayer silicon carbide stack;
(e) patterning the second dielectric layer to define interconnects therein, wherein the interconnects are positioned over the vias defined in the multilayer silicon carbide stack;
(f) transferring the via pattern through the first dielectric layer using the multilayer silicon carbide stack as a hardmask; and
(g) filling the vias and interconnects with a conductive material.

4. The method of claim 3 wherein the first dielectric layer and the second dielectric layer each have a dielectric constant less than 3.0.

5. The method of claim 4 wherein either of the first dielectric layer and the second dielectric layer are selected from the group of silicon dioxide, fluorosilicate glass (FSG), undoped silicate glass (USG), organosilicates, and combinations thereof.

6. The method of claim 2 or 3 wherein the conductive material filling the vias and the interconnects has a resistivity less than 10 µΩ-cm (microohms-centimeter).

7. The method of claim 2 or 3 wherein the conductive material filling the vias and the interconnects is selected from the group of copper (Cu), aluminum (Al), tungsten (W), and combinations thereof.

8. The method of claim 2 or 3 wherein the multilayer silicon carbide stack is formed on the first dielectric layer by
(a) forming a silicon carbide seed layer on the substrate;
(b) treating the silicon carbide seed layer with a helium containing plasma; and
(c) forming a silicon carbide layer on the plasma treated silicon carbide layer.

9. The method of any of the preceding claims wherein the silicon carbide seed layer is treated with the helium containing plasma for less than 60 seconds.

10. The method of claim 9 wherein steps (a) or (c), comprise:
positioning the substrate in a deposition chamber;
providing a gas mixture to the deposition chamber wherein the gas mixture comprises a silicon source, a carbon source, and an inert gas; and
reacting the gas mixture in the presence of an electric field to form a silicon carbide layer on the substrate.

11. The method of claim 10 wherein the silicon source and the carbon source comprise an organosilane compound having the general formula SiₓC_{y}H_{z}, wherein x has a range of 1 to 2, y has a range of 1 to 6, and z has a range of 4 to 20.

12. The method of claim 11 wherein the organosilane compound is selected from the group of methylsilane (SiCH₆), dimethylsilane (SiC₂H₈), trimethylsilane (SiC₃H₁₀), tetramethylsilane (SiC₄H₁₂), diethylsilane (SiC₄H₁₂), and combinations thereof.

13. The method of claim 10 wherein the silicon source and the carbon source are selected from the group of silane (SiH₄), methane (CH₄), disilane (Si₂H₆), and combinations thereof.

14. The method of claim 10 wherein the inert gas is selected from the group of argon (Ar), helium (He), neon (Ne), xenon (Xe), and combinations thereof.

15. The method of claim 8 wherein the helium containing plasma of step (b) is generated by providing a helium containing gas to a process chamber; and applying an electric field to the helium containing gas in the process chamber to generate the helium containing plasma.

16. The method of claim 10 or 15 wherein the electric field is generated from a radio frequency (RF) power.

17. A computer storage medium containing a software routine that, when executed, causes a general purpose computer to control a deposition chamber using a layer deposition method according to any of the claims 1 to 16.

18. A multilayer silicon carbide stack, comprising a plasma treated silicon carbide seed layer formed on a substrate; and a silicon carbide layer formed on the plasma treated silicon carbide seed layer.

19. A multilayer silicon carbide stack of claim 18 formed according to the method of any of the claims 1 to 16.
